# EUROPEAN PATENT SPECIFICATION

(11) **EP 0 327 244 B1**
(45) Date of publication and mention of the grant of the patent: **16.06.1993**
(21) Application number: 89300667.6
(22) Date of filing: 25.01.1989
(51) Int. Cl.: A47G 21/18, B65D 77/28

(54) **Improvements in or relating to drinking straws**
Trinkhalme
Pailles

(30) Priority: 04.02.1988 GB 8802476
(43) Date of publication of application: 09.08.1989
(73) Proprietor: ELOPAK SYSTEMS AG, CH-8152 Glattbrugg (CH)
(72) Inventor: Meierhofer, Rudolf, CH-8157 Dielsdorf (CH)
(74) Representative: Burrows, Anthony Gregory

(56) References cited:
- DE-A- 2 828 881
- US-A- 3 189 171
- US-A- 4 036 392

## Description

This invention relates to a drinking straw and to a gable-topped carton carrying the straw.

British Patent 1452123 discloses a drinking straw flattened along at least a portion of its length, the walls of the flattened portion each being provided with two sets of impressions arranged in parallel and such that those of one wall correspond to and overlie those of the other wall, whereby pressure applied to the two side edges of the portion by the thumb and forefinger of a consumer causes bending of the two walls intermediate the edges so as to give the portion a substantially square cross-section. The straw is made of plastics or other suitable resilient material, is often wrapped and is preferably attached to each bottle, can or carton, sold in normal retail outlets or dispensed by a vending machine, although, alternatively, the straw could be sold in bulk. In the embodiment in which the straw is fixed to a gable-topped carton, such flattened, wrapped, sealed, and folded straw is affixed to one of the two downwardly and outwardly sloping, gable end panels of the top closure of a gable-topped plastics-coated carton, such as is used for holding milk or juice beverages. This straw is retained by a gummed label or by direct gluing of the back of the wrapper onto the carton. An alternative location to affix the straw to the carton, is a side of the mouth of the carton, machine placement of the straw being used. The method undertaken by the consumer of preparing the straw for use comprises extending the flattened straw to its full length, passing the flattened straw through a restricted space determined preferably by the position of the customer's thumb and forefinger. This action presses the originally folded opposite edges towards one another effectively to open and then to reflatten the straw again but in a different direction. This folding operation by the consumer is intended to create two new opposite edges or rounded corners which, upon release of the pressure and in conjunction with the two originally folded edges and supplemented by the four patterned sectional areas, allow a second inherent resiliency recovery resulting in a formation of a substantially square straw ready for use. This drinking straw and its arrangement upon the carton suffer from a number of disadvantages. Firstly, the manner of preparing the straw for use is not obvious to the customer without some explanation, which customers are liable to ignore anyway. Moreover, the fold locations of the known straw are not more bendable than other portions thereof. Placement of the straw in the recess bounded by the sloping gable end panel would allow a very limited length of strength, nor does it readily allow machine placement, which is obviously highly desirable in mass production of filled cartons. Moreover, affixing of the straw to a side of the mouth of the carton, which mouth is defined by the sealing fin, also provides a relatively restricted area and thus significantly limits the length of straw applicable thereto.

United States Patent 4036392 discloses a disposable lid for a disposable beverage container having a recess centrally formed in the exterior top surface thereof adapted to carry readily removably secured therein a foldable drinking straw. The straw includes two transversely corrugated bellows portions, the centres of which are spaced apart a distance substantially equal to one-half of the total length of the straw, and which are each bendable into a half-loop configuration. The straw further includes a straight portion extending between the two bellows portions, as well as two shorter terminal straight portions. The straw is foldable until the opposite ends thereof are substantially in abutment, and the straight terminal portions thereof are substantially in alignment, and the recess provided in the lid is proportioned to receive the straw in such folded condition. The lid has small projecting portions adjacent the side walls of the recess and serving to retain the folded drinking straw therein, until manually removed therefrom. The recess further includes an enlargement into which a finger tip may be inserted for facilitating the removal of the folded straw. After removal from the recess the straw is straightened for use.

With this arrangement, a recess has to be specially provided in the lid to receive the straw. Moreover, the length of the straw is not greater than twice the length of the recess, and the straw is no protected against foreign matter.

United States Patent 4247016 discloses a similar lid-straw combination, the lid being recessed over most of its plan area and the straw having most of its length extending along the periphery of that recess. One end of the straw passes through the lid, removable cover sheets being provided over the protruding portion and the entire upper surface of the lid to maintain a sanitary condition. Again in this arrangement, a recess is specially provided to receive the straw. Moreover, the straw covers a relatively large area.

European Patent Application Publication 0053305 discloses a gable-topped carton carrying a drinking straw, which may be contained in an envelope and placed so that it extends over two wall panels adjoining each other and situated at an angle to each other, in the case shown over one of the sloping roof panels and the side wall panel immediately below that panel. The tube is bent at an appropriate angle and is placed along the joint diagonal line of the two wall panels.

To apply the drinking straw and its envelope to the two wall panels, one bottom corner of the side wall panel is provided with a coating of thermoplastics, so-called hot-melt, and the drinking straw, possibly wrapped in an envelope, is brought into contact with the holt-melt before the same has had time to cool off. Then further hot-melt is applied to the opposite top corner of the sloping roof panel and the drinking straw/envelope is bent so that its free end will rest against the still warm and soft hot-melt at that opposite top corner. A significant risk with this arrangement is that the part of the drinking straw extending over the side wall is liable to be damaged or torn off during handling of the carton when the side wall comes into contact with other cartons or with conveying or storage surfaces. Furthermore, the straw is liable to be damaged at the bend therein, because this bend is disposed at the outside of the angle between the sloping roof panel and the side wall panel.

USA-A-3189171 discloses a telescopic straw mounted in a wrapper affixed on a slant to a side wall of a square carton, or diagonally in a depressed lid of a square carton, or to a sloping roof panel of a gable-topped carton.

According to one aspect of the present invention, there is provided in combination, a drinking straw and a carrier therefor, said straw extending substantially in a plane and comprising substantially linear first, second and third tubular parts alternating along the straw with substantially semi-circular fourth and fifth tubular parts which are more readily bendable than the first, second and third tubular parts, characterized in that said carrier is an envelope enclosing said straw and in that two of the first, second and third tubular parts are located at respective opposite sides of the other of the first, second and third tubular parts, so that these two tubular parts lie side-beside with that other tubular part.

According to another aspect of the present invention there is provided a packaging method, comprising
forming a drinking straw of a form in which said straw extends substantially in a plane, in which substantially linear first, second and third tubular parts alternate along the straw with substantially semi-circular fourth and fifth tubular parts which are more readily bendable than the first, second and third tubular parts, and in which two of the first, second and third tubular parts are located at respective opposite sides of the other of the first, second and third tubular parts, so that these two tubular parts lie side-by-side with that other tubular part, and
enclosing said straw in said form in an envelope.

An advantage of this arrangement of parts of the straw is that the extended length of the straw, in relation to the overall area occupied by the bent straw as viewed perpendicularly to its plane, is relatively large.

Advantageously, the first and third tubular parts are located at respective opposite sides of the second tubular part.

An advantage of this arrangement, which is effectively a meandering form, is that the form can accommodate any suitable number of substantially linear tubular parts, and can thereby accommodate any suitable desired extended length of straw.

In a preferred embodiment, there is provided in combination, a gable-topped carton including a gabled top closure including an upwarding protruding sealing fin having an upper boundary, a lower boundary and two end boundaries, and first and second roof panels extending along said lower boundary and downwardly and outwardly away from each other from respective opposite sides of said lower boundary, whereby said first roof panel bounds, with said sealing fin, an angular recess, said first roof panel having an upper boundary substantially co-inciding with the upper boundary of the sealing fin, a lower boundary, and two end boundaries each extending obliquely downwards, and said recess being bounded by the upper boundary and the two end boundaries of said fin and by the lower boundary and the two end boundaries of said first roof panel, fluid material contained in said carton, and the drinking straw in the envelope, which is mounted in said recess and does not extend substantially beyond said upper boundary and said two end boundaries of said fin and said lower boundary and said two end boundaries of said first roof panel.

This arrangement has a number of advantages. First of all, there is no need to provide a special recess to receive the straw; an existing recess is used. Secondly, the sloping roof panel provides the largest possible recess area on the outside of a gable-topped carton for placement of a drinking straw, so that the straw can be relatively long. Furthermore, the straw is reasonably well protected against damage or undesired ripping-off reasonably well protected against damage or undesired ripping-off from the outside of the gable-topped carton.

For such reasons, the envelope advantageously terminates short of the boundaries of the recess as seen in plan and as seen in side elevation. Moreover, the envelope is preferably substantially totally contained within the volume of the recess.

In order that the invention may be clearly understand and readily carried into effect, reference will now be made, by way of example, to the accompanying drawings, in which:
Figure 1 shows a side elevation of a drinking straw in a collapsed, in this case folded, condition,
Figure 2 shows a perspective view of the straw of Figure 1 sealed in a plastics film bag,
Figure 3 shows a fragmentary perspective view of the top of a gable-topped carton, carrying externally of the gable top, the straw in its bag, and
Figure 4 shows a vertical sectional view of the carton with the straw in an extended condition in the carton.

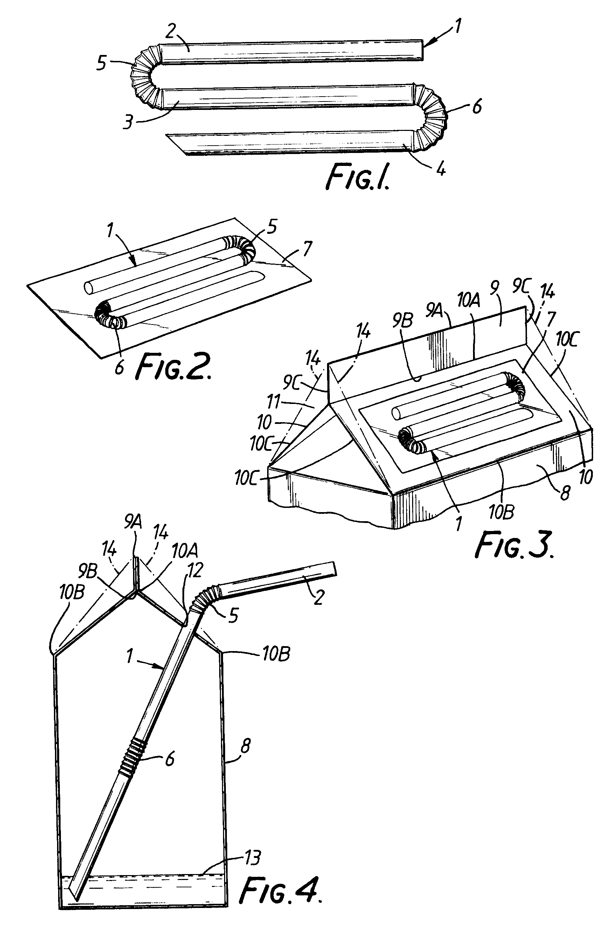

Referring to Figure 1, the straw 1 consists of three linear tubular parts 2 to 4 alternating along the straw with two bendable tubular parts 5 and 6 which are each in the form of a tubular shrink bellows and are more readily bendable than are the parts 2 to 4. The straw extends substantially in a plane and the parts 2 and 4 are located at respective opposite sides of the part 3, so that the straw assumes a general S-shape in its folded condition shown in Figure 1.

Figure 2 shows the straw sealed in a plastics film bag 7 which is advantageously transparent.

Figure 3 shows the top of a conventional gable-topped carton 8, with its top sealing fin 9 and its two sloping roof panels 10. The upwardly protruding sealing fin 9 has an upper boundary 9A, a lower boundary 9B and two end boundaries 9C. The roof panels 10 extend along the lower boundary 9B and downwardly outwardly away from each other from respective opposite sides of the lower boundary 9B, whereby each roof panel 10 bounds, with the sealing fin 9, an angular recess 11. Each of the roof panels 10 has an upper boundary 10A co-inciding with the lower boundary 9B, a lower boundary 10B and two end boundaries 10C each extending obliquely downwards. Thus, each recess 11 is bounded by the upper boundary 9A and the two end boundaries 9C of the fin 9 and by the lower boundary 10B and the two end boundaries 10C of the relevant roof panel 10. The recess 11 is in effect a volume defined by the boundaries of the fin 9, by the boundaries of its associated roof panel 10, and by two imaginary straight lines 14 extending obliquely downwards from the respective ends of the upper boundary 9A to the respective ends of the lower boundary 10B of the relevant panel 10. The bag 7, containing the folded straw 1, is received within that volume of one of the recesses 11, so that neither projects out of that recess. The bag 7 is adhered, for example by hot-melt, to the roof panel 10. The locating of the straw 1 within the recess 11 significantly reduces the risk of the bag 7 and the straw 1 being crushed or torn off the carton during handling of the carton.

To use the straw, the bag 7 is pulled from the roof panel 10 and then torn open and the straw 1 is extracted therefrom. Then the straw is extended, by unfolding about the parts 5 and 6, and thereafter inserted through a strawhole 12 in the carton 8, as shown in Figure 4, in which the straw 1 is seen reaching the liquid 13 in the very bottom of the carton 8.

It will be understood that, the taller the carton in proportion to the area of its roof panel 10, the more bendable parts (such as 5 and 6) will be required in the straw.

## Claims

1. In combination, a drinking straw (1) and a carrier (7) therefor, said straw (1) extending substantially in a plane and comprising substantially linear first, second and third tubular parts (2, 3, 4) alternating along the straw (1) with substantially semi-circular fourth and fifth tubular parts (5, 6) which are more readily bendable than the first, second and third tubular parts (2, 3, 4), characterized in that said carrier (7) is an envelope (7) enclosing said straw (1) and in that two of the first, second and third tubular parts (2, 3, 4) are located at respective opposite sides of the other of the first, second and third tubular parts (2, 3, 4), so that these two tubular parts (2,4) lie side-by-side with that other tubular part (3).

2. A combination according to claim 1, wherein the first and third tubular parts (2, 4) are located at respective opposite sides of the second tubular part (3).

3. An assembly comprising a gable-topped carton (8) including a gabled top closure (9,10) including on upwardly protruding sealing fin (9) having an upper boundary (9A), a lower boundary (9B) and two end boundaries (9C), and first and second roof panels (10) extending along said lower boundary (9B) and downwardly and outwardly away from each other from respective opposite sides of said lower boundary (9B) whereby said first roof panel (10) bounds, with said sealing fin (9), an angular recess (11), said first roof panel (10) having an upper boundary (10A) substantially co-inciding with the lower boundary (9B) of the sealing fin (9), a lower boundary (10B), and two end boundaries (10C) each extending obliquely downwards, and said recess (11) being bounded by the upper boundary (9A) and the two end boundaries (9C) of said fin (9) and by the lower boundary (10B) and the two end boundaries (10C) of said first roof panel (10), fluid material (13) contained in said carton (8), a combination (1, 7) according to claim 1 or 2 mounted on said carton (8), said envelope (7), by way of which said straw (1) is mounted on said carton (8), not extending substantially beyond said upper boundary (9A) and said two end boundaries (9C) of said fin (9) and said lower boundary (10B) and said two end boundaries (10C) of said first roof panel (10).

4. An assembly according to claim 3, wherein said recess (11) is a volume defined by the boundaries (9A-9C) of said fin (9), by the boundaries (10A-10C) of said first roof panel (10) and by first and second imaginary straight lines (14) extending obliquely downwards from the respective ends of said upper boundary (9A) of said fin (9) to the respective adjacent ends of said lower boundary (10B) of said first roof panel (10), and said straw (1) and said envelope (7) are substantially totally contained within said volume.

5. A packaging method, comprising
forming a drinking straw (1) of a form in which said straw (1) extends substantially in a plane, in which substantially linear first, second and third tubular parts (2, 3, 4) alternate along the straw (1) with substantially semi-circular fourth and fifth tubular parts (5, 6) which are more readily bendable than the first, second and third tubular parts (2, 3, 4), and in which two of the first, second and third tubular parts (2, 3, 4) are located at respective opposite sides of the other of the first, second and third tubular parts (2, 3, 4), so that these two tubular parts (2,4) lie side-by-side with that other tubular part (3), and
enclosing said straw (1) in said form in an envelope (7).

6. A method according to claim 5, and further comprising
mounting said envelope (7) containing said straw (1) on a gable-topped carton (8) including a gabled top closure (9,10) including an upwardly protruding sealing fin (9) having an upper boundary (9A), a lower boundary (9B) and two end boundaries (9C), and first and second roof panels (10) extending along said lower boundary (9B) and downwardly and outwardly away from each other from respective opposite sides of said lower boundary (9B) whereby said first roof panel (10) bounds, with said sealing fin (9), an angular recess (11), said first roof panel (10) having an upper boundary (10A) substantially co-inciding with the lower boundary (9B) of the sealing fin (9), a lower boundary (10B), and two end boundaries (10C) each extending obliquely downwards, and said recess (11) being bounded by the upper boundary (9A) and the two end boundaries (9C) of said fin (9) and by the lower boundary (10B) and the two end boundaries (10C) of said first roof panel (10), said envelope (7) being mounted on said first roof panel (10) and not extending substantially beyond said upper boundary (9A) and said two end boundaries (9C) of said fin (9) and said lower boundary (10B) and said two end boundaries (10C) of said first roof panel (10).

## Patentansprüche

1. Kombination aus einem Trinknalm (1) und einem Träger (7) für diesen, wobei sich der Trinkhalm (1) im wesentlichen in einer Ebene erstreckt und ein im wesentlichen lineares erstes, zweites und drittes rohrförmiges Teil (2, 3, 4) aufweist, die sich entlang des Trinkhalms (1) mit einem im wesentlichen halbkreisförmigen Vierten und fünften rohrförmigen Teil (5, 6) abwechseln, die leichter biegbar sind als das erste, zweite und dritte Teil (2, 3, 4), dadurch gekennzeichnet, daß der Träger (7) eine den Trinkhalm (1) umschließende Hülle (7) ist und daß zwei der ersten, zweiten und dritten rohrförmigen Teile (2, 3, 4) zu den dem anderen der ersten, zweiten oder dritten rohrförmigen Teile (2, 3, 4) jeweils gegenüberliegenden Seiten angeordnet sind, so daß diese beiden rohrförmigen Teile (2, 4) neben dem anderen rohrförmigen Teil (3) liegen.

2. Kombination nach Anspruch 1, bei der das erste und das dritte rohrförmige Teil (2, 4) zu jeweils gegenüberliegenden Seiten des zweiten rohrförmigen Teils (3) angeordnet sind.

3. Anordnung mit einem am oberen Ende giebelförmig ausgebildeten Karton (8), der einen giebelförmigen oberen Verschluß (9, 10) aufweist, der eine nach oben vorstehende Siegellasche (9) mit einer oberen Begrenzung (9A), einer unteren Begrenzung (9B) und zwei Endbegrenzungen (9C) und eine erste und eine zweite Dachbahn (10) aufweist, die sich entlang der unteren Begrenzung (9B) und von jeweils gegenüberliegenden Seiten der unteren Begrenzung (9B) voneinander weg nach unten und außen erstrecken, wobei die erste Dachbahn (10) mit der Siegellasche (9) eine winklige Ausnehmung (11) begrenzt, wobei die erste Dachbahn (10) eine obere Begrenzung (10A), die im wesentlichen mit der unteren Begrenzung (9B) der Siegellasche (9) zusammenfällt, eine untere Begrenzung (10B) und zwei sich jeweils schräg nach unten erstrekkende Begrenzungen (10C) aufweist, und wobei die Ausnehmung (11) von der oberen Begrenzung (9A) und den beiden Endbegrenzungen (9C) der Lasche (9) sowie der unteren Begrenzung (10B) und den beiden Endbegrenzungen (10C) der ersten Dachbahn (10) begrenzt ist, mit in dem Karton (8) enthaltenem flüssigem Material (13), einer Kombination (1, 7) nach Anspruch 1 oder 2, die an dem Karton (8) befestigt ist, wobei sich die Hülle (7) mittels derer der Trinkhalm (1) an dem Karton (8) befestigt ist, nicht wesentlich über die obere Begrenzung (9A) und die beiden Endbegrenzungen (9C) der Lasche (9) sowie die untere Begrenzung (10B) und die beiden Endbegrenzungen (10C) der ersten Dachbahn (10) erstreckt.

4. Anordnung nach Anspruch 3, bei der die Ausnehmung (11) ein Volumen ist, das von den Begrenzungen (9A-C) der Lasche (9), den Begrenzungen (10A-C) der ersten Dachbahn (10) und einer ersten und zweiten imaginären Geraden (14) begrenzt ist, die sich von den jeweiligen Enden der oberen Begrenzung (9A) der Lasche (9) schräg nach unten zu den jeweiligen benachbarten Enden der unteren Begrenzung (10B) der ersten Dachbahn (10) erstrecken, und bei der der Trinkhalm (1) und die Hülle (7) im wesentlichen vollständig in dem Volumen enthalten sind.

5. Verpackungsverfahren mit den folgenden Schritten:
- Bilden eines Trinkhalms (1) mit einer Form, bei der sich der Trinkhalm (1) im wesentlichen in einer Ebene erstreckt, bei der ein im wesentlichen lineares erstes, zweites und drittes rohrförmiges Teil (2, 3, 4) sich entlang des Trinkhalms (1) mit einem im wesentlichen halbkreisförmigen vierten und fünften rohrförmigen Teil (5, 6) abwechseln, die leichter biegbar sind als das erste, zweite und dritte Teil (2, 3, 4), und bei der zwei der ersten, zweiten und dritten rohrförmigen Teile (2, 3, 4) zu den dem anderen der ersten, zweiten oder dritten rohrförmigen Teile (2, 3, 4) jeweils gegenüberliegenden Seiten angeordnet sind, so daß diese beiden rohrförmigen Teile (2, 4) neben dem anderen rohrförmigen Teil (3) liegen, und
- Einschließen des derart geformten Trinkhalms (1) in einer Hülle (7).

6. Verfahren nach Anspruch 5, ferner mit dem folgenden Schritt:
- Befestigen der den Trinkhalm (1) enthaltenden Hülle (7) auf einem mit giebelförmigem oberem Ende allsgebildeten Karton (8), welcher einen giebelförmigen oberen Verschluß (9, 10) aufweist, der eine nach oben vorstehende Siegellasche (9) mit einer oberen Begrenzung (9A), einer unteren Begrenzung (9B) und zwei Endbegrenzungen (9C) und eine erste und eine zweite Dachbahn (10) aufweist, die sich entlang der unteren Begrenzung (9B) und von jeweils gegenüberliegenden Seiten der unteren Begrenzung (9B) voneinander weg nach unten und außen erstrecken, wobei die erste Dachbahn (10) mit der Siegellasche (9) eine winklige Ausnehmung (11) begrenzt, wobei die erste Dachbahn (10) eine obere Begrenzung (10A), die im wesentlichen mit der unteren Begrenzung (9B) der Siegellasche (9) zusammenfällt, eine untere Begrenzung (10B) und zwei sich jeweils schräg nach unten erstreckende Begrenzungen (10C) aufweist, und wobei die Ausnehmung (11) von der oberen Begrenzung (9A) und den beiden Endbegrenzungen (9C) der Lasche (9) sowie der unteren Begrenzung (10B) und den beiden Endbegrenzungen (10C) der ersten Dachbahn (10) begrenzt ist, wobei die Hülle (7) an der ersten Dachbahn (10) befestigt ist und sich nicht wesentlich über die obere Begrenzung (9A) und die beiden Endbegrenzungen (9C) der Lasche (9) sowie die untere Begrenzung (10B) und die beiden Endbegrenzungen (10C) der ersten Dachbahn (10) erstreckt.

## Revendications

1. En combinaison, une paille à boire (1) et son support (7), ladite paille (1) s'étendant sensiblement dans un plan et comprenant de première seconde et troisième parties tubulaires sensiblement linéaires (2, 3, 4) alternant le long de la paille (1) avec de quatrième et cinquième parties tubulaires sensiblement semi-circulaires (5, 6) qui sont plus facilement repliables que les première, seconde et troisième parties tubulaires (2, 3, 4), caractérisés en ce que ledit support (7) est une enveloppe (7) renfermant ladite paille (1) et en ce que deux des première, seconde et troisième parties tubulaires (2, 3, 4) dont disposées sur les côtés opposés respectifs de l'autre des première, seconde et troisième parties tubulaires (2, 3, 4), de sorte que ces deux parties tubulaires (2, 4) soient côte à côte avec cette autre partie tubulaire (3).

2. Une combinaison selon la revendication 1, dans laquelle les première et troisième parties tubulaires (2, 4) sont disposées sur les côtés opposés respectifs de la seconde partie tubulaire (3).

3. Une disposition comprenant un emballage de carton à toit pointu (8) comportant une fermeture à toit pointu (9, 10) comprenant une nervure d'étanchéité (9) saillant vers l'extérieur présentant une démarcation supérieure (9A), une démarcation inférieure (9B) et deux démarcations d'extrémité (9C) et de premier et second pans de toit (10) s'étendant le long de ladite démarcation inférieure (9B), vers le bas et vers l'extérieur en s'éloignant l'un de l'autre à partir des côtés opposés respectifs de ladite démarcation inférieure (9B), de sorte que ledit premier pan de toit (10) délimite, avec ladite nervure d'étanchéité (9), un évidement angulaire (11), ledit premier pan de toit (10) présentant une démarcation supérieure (10A) coïncidant sensiblement avec la démarcation inférieure (9B) de la nervure d'étanchéité (9), une démarcation inférieure (10B), et deux démarcations d'extrémité (10C) s'étendant chacune en oblique vers le bas, et ledit évidement (11) étant délimité par la démarcation supérieure (9A) et les deux démarcations d'extrémité (9C) de ladite nervure (9) et par la démarcation inférieure (10B) et les deux démarcations d'extrémité (10C) dudit premier pan de toit (10), une matière fluide (13) contenue dans ledit emballage de carton (8) une combinaison (1, 7) selon la revendication 1 ou 2 disposée sur ledit emballage de carton (8), ladite enveloppe (7), par le moyen de laquelle ladite paille (1) est mise en place sur ledit carton (8), en ne s'étendant pas sensiblement au-delà de ladite démarcation supérieure (9A) et desdites deux démarcations d'extrémité (9C) de ladite nervure (9) et au-delà de ladite démarcation inférieure (10B) et desdites deux démarcations d'extrémité (10C) dudit premier pan de toit (10).

4. Une disposition selon la revendication 3, dans laquelle l'évidement (11) est un volume défini par les démarcations (9A-9C) de ladite nervure (9), par les démarcations (10A-10C) dudit premier pan de toit (10) et par de première et seconde lignes droites imaginaires (14) s'étendant en oblique vers le bas à partir des extrémités respectives de ladite démarcation supérieure (9A) de ladite nervure (9) vers les extrémités adjacentes respectives de ladite démarcation inférieure (10B) dudit premier pan de toit (10) et ladite paille (1) et ladite enveloppe (7) étant sensiblement contenues en entier à l'intérieur dudit volume.

5. Un procédé d'emballage comprenant,
la formation d'une paille à boire (1) d'une forme dans laquelle ladite paille (1) s'étend sensiblement dans un plan et comprend de première, seconde, troisième parties tubulaires sensiblement linéaires (2, 3, 4) alternant le long de la paille (1) avec de quatrième et cinquième parties tubulaires sensiblement semi-circulaires (5, 6), qui sont plus facilement repliables que les première, seconde et troisième parties tubulaires (2, 3, 4), et dans laquelle deux des première, seconde et troisième parties tubulaires (2, 3, 4) sont disposées sur les côtés opposés respectifs de l'autre des première, seconde et troisième parties tubulaires (2, 3, 4), de sorte que ces deux parties tubulaires (2, 4) soient côte à côte avec cette autre partie tubulaire (3), et
l'inclusion de ladite paille (1), dans ladite forme, dans une enveloppe (7).

6. Un procédé selon la revendication 5, et comprenant en outre
la mise en place de ladite enveloppe (7) contenant ladite paille (1) sur un emballage de carton à toit pointu (8) comportant une fermeture à toit pointu (9, 10) comprenant une nervure d'étanchéité (9) saillant vers l'extérieur présentant une démarcation supérieure (9A), une démarcation inférieure (9B) et deux démarcations d'extrémité (9C), et de premier et second pans de toit (10) s'étendant le long de ladite démarcation inférieure (9B), vers le bas et vers l'extérieur en s'éloignant l'un de l'autre à partir des côtés opposés respectifs de ladite démarcation inférieure (9B), de sorte que ledit premier pan de toit (10) délimite, avec ladite nervure d'étanchéité (9), un évidement angulaire (11), ledit premier pan de toit (10) présentant alors une démarcation supérieure (10A) coïncidant sensiblement avec la démarcation inférieure (9B) de la nervure d'étanchéité (9), une démarcation inférieure (10B), et deux démarcations d'extrémité (10C) s'étendant chacune en oblique vers le bas, et ledit évidement (11) étant délimité par la démarcation supérieure (9A) et les deux démarcations d'extrémité (9C) de ladite nervure (9) et par la démarcation inférieure (10B) et les deux démarcations d'extrémité (10C) dudit premier pan de toit (10), ladite enveloppe (7) étant montée sur ledit premier pan de toit (10) et ne s'étendant pas sensiblement au-delà de ladite démarcation supérieure (9A) et desdites deux démarcations d'extrémité (9C) de ladite nervure (9) et au-delà de ladite démarcation inférieure (10B) et desdites deux démarcations d'extrémité (10C) dudit premier pan de toit (10).
